Europäisches Patentamt

European Patent Office

Office européen des brevets

(11) Veröffentlichungsnummer: **0 027 519**

A1

## (12) EUROPÄISCHE PATENTANMELDUNG

(21) Anmeldenummer: 80104994.1

(22) Anmeldetag: 22.08.80

(51) Int. Cl.³: **H 03 G 3/32**

(30) Priorität: 19.10.79 DE 2942331

(43) Veröffentlichungstag der Anmeldung:
29.04.81 Patentblatt 81 17

(84) Benannte Vertragsstaaten:
AT FR IT SE

(71) Anmelder: Blaupunkt-Werke GmbH
Robert-Bosch-Strasse 200
D-3200 Hildesheim(DE)

(72) Erfinder: Voessing, Walter, Dipl.-Ing.
Westpreussenstrasse 2
D-3200 Hildesheim(DE)

(72) Erfinder: Wellhausen, Heinz, Dipl.-Ing.
Trockener Kamp 92
D-3200 Hildesheim(DE)

(74) Vertreter: Eilers, Norbert, Dipl.-Phys.
Robert-Bosch-Strasse 200
D-3200 Hildesheim(DE)

(54) Schaltungsanordnung zum selbsttätigen Einstellen der Lautstärke eines Lautsprechers in Abhängigkeit von einem am Lautsprecherort herrschenden Störgeräuschpegel.

(57) Schaltungsanordnung, insbesondere für mobile Rundfunkempfänger, wie Autoradios od. dgl., die über den gesamten Steuer- bzw. Regelbereich der Lautstärke des Lautsprechers (10) stabil arbeitet und bei welcher jeglicher Einfluß des Lautsprechersignals auf die Stellgröße für den Lautstärkeregler (11) ausgeschaltet ist. Die Schaltungsanordnung weist einen Lautstärkeregler (11) mit zugeordnetem Stellglied (12), ein Lautsprecher- und Störgeräuschsignal erfassendes und eine entsprechende Ausgangsspannung erzeugendes Mikrofon (13), Gleichrichtstufen (19,24) für die Ausgangsspannungen von Lautstärkeregler und Mikrofon, Quadriernetzwerke (18,23) zum Quadrieren der gleichgerichteten Ausgangsspannungen von Lautstärkeregler und Mikrofon und eine Summierschaltung (17) auf, in welcher die quadrierten Ausgangsspannungen von Lautstärkeregler und Mikrofon voneinander subtrahiert werden. Die Ausgangsspannung der Summierschaltung wird entsprechend angepaßt dem Stellglied des Lautstärkereglers zugeführt.

./...

Blaupunkt-Werke GmbH
R.Nr. 1647

Blaupunkt-Werke GmbH                9. Oktober 1979
3200 Hildesheim

Schaltungsanordnung zum selbsttätigen Einstellen der Lautstärke eines Lautsprechers
in Abhängigkeit von einem am Lautsprecherort herrschenden Störgeräuschpegel

Die Erfindung betrifft eine Schaltungsanordnung zum selbsttätigen Einstellen der Lautstärke eines Lautsprechers in
Abhängigkeit von einem am Lautsprecherort herrschenden
Störgeräuschpegel, insbesondere für mobile Rundfunkempfänger, wie Autoradios od. dgl., der im Oberbegriff des
Anspruchs 1 definierten Gattung.

Mit einer solchen Schaltungsanordnung wird die Lautstärke
entsprechend dem Geräuschpegel in der Umgebung des Lautsprechers so eingestellt, daß der Wiedergabepegel des
Lautsprechers, also der Nutzsignalpegel, immer um einige
Dezibel (dB) höher liegt als der Störgeräuschpegel, so daß
das vom Lautsprecher abgestrahlte Nutzsignal von dem
Hörenden, unabhängig von dem jeweiligen Stärkegrad der
Umweltgeräusche, in etwa immer gleich laut empfunden wird.
Insbesondere für den mobilen Betrieb des beispielsweise
mit einem Rundfunkempfänger verbundenen Lautsprechers, wie
in Kraftfahrzeugen, bedeutet dies eine wesentliche Verbesserung des Bedienungskomforts, da der Hörende nicht mehr
gezwungen ist, bei häufig wechselndem Störgeräuschpegel
ständig die Lautstärke des Lautsprechers nachzustellen.

Bei einer bekannten Schaltungsanordnung der eingangs genannten Art erfolgt die Verknüpfung der gleichgerichteten Ausgangsspannungen von Lautstärkeregler  und Mikrofon
durch Subtraktion dieser Ausgangsspannungen in der Summierschaltung. Die am Ausgang der Summierschaltung auftretende
Differenzspannung wird entsprechend verstärkt dem Stellgliedeingang zugeführt.

Es hat sich gezeigt, daß diese Schaltungsanordnung nicht
befriedigt, da sie nur in einem kleinen Bereich einigermaßen stabil arbeitet und den angestrebten Effekt der
Lautstärkeanpassung  erzielen kann. Größere Störgeräuschpegeländerungen führen hingegen zu einem unerwünschten
Aufschaukeln der Schaltungsanordnung, als deren Folge je
nach Grundeinstellung des Lautstärkereglers die Lautstärke
des Lautsprechers stetig anwächst oder absinkt. Der gleiche
Effekt wird auch bei wesentlicher Änderung der Lautstärke -
grundeinstellung des Lautstärkereglers beobachtet. Der
stabile Bereich der Schaltungsanordnung muß durch eine
recht umständliche Grundjustierung der Schaltungsanordnung
nach Einbau an ihrem Einsatzort, wie z.B. im Kraftfahrzeuginnenraum, aufgesucht werden.

Die Ursache für das unbefriedigende Arbeiten der bekannten
Schaltungsanordnung liegt darin, daß durch die Subtraktion
der der Summierschaltung zugeführten Ausgangsspannungen
von Lautstärkeregler und Mikrofon eine Kompensation der
von dem Lautsprechersignal herrührenden Spannungskomponente in der Mikrofonausgangsspannung durch die Ausgangsspannung des Lautstärkereglers sich nicht erreichen läßt,
da durch die Gleichrichtung die zeitliche Zuordnung des von
dem Mikrofon aufgenommenen Summensignals aus Störsignal
und Lautsprechersignal zu dem dem Lautsprecher zugeführten
Ausgangssignal des Lautstärkereglers als Voraussetzung für eine Kompensation verlorengeht. Die am Ausgang der Summierschaltung abgenommene
Stellgröße für das Stellglied des Lautstärkereglers ist
nach wie vor von der Ausgangsspannung des Lautstärkereglers bzw. dem Lautsprechersignal abhängig, die bzw. das sich bei
Justierung der bekannten Schaltungsanordnung praktisch nur in
einem einzigen Punkt, und zwar bei einer bestimmten Ausgangsspannung des Lautstärkereglers und einem ganz bestimmten Störgeräuschpegel exakt eliminieren läßt. Mit
anderen Worten gibt es bei der bekannten Schaltungsanordnung nur ein einziges Wertepaar von Lautsprechersignal
und Störgeräuschsignal, bei dem der Einfluß der Ausgangsspannung des Lautstärkereglers bzw. des Lautsprechersignals auf die Stellgröße zum Einstellen des Lautstärkereglers völlig aufgehoben ist.

Der Erfindung liegt die Aufgabe zugrunde, eine Schaltungsanordnung der eingangs genannten Art zu schaffen, bei
welcher sich unter Vermeidung der vorstehend beschriebenen Nachteile die Abhängigkeit der dem Stellglied für den
Lautstärkeregler zugeführten Stellgröße von der Ausgangsspannung des Lautstärkereglers bzw. von dem Lautsprechersignal vollständig ausschalten läßt.

Diese Aufgabe ist bei einer Schaltungsanordnung der im
Oberbegriff des Anspruchs 1 definierten Gattung erfindungsgemäß durch die Merkmale im Kennzeichnungsteil des Anspruchs 1 gelöst.

Bei der erfindungsgemäßen Schaltungsanordnung werden nicht
wie bisher die Ausgangsspannungen von Lautstärkeregler
und Mikrofon subtrahiert sondern die Quadrate dieser Ausgangsspannungen. Wie sich leicht nachweisen läßt, kann dadurch am Ausgang der Summierschaltung eine Stellgröße oder
Stellsignalspannung für das Stellglied des Lautstärkereglers abgenommen werden, die ausschließlich von der Größe
des Störsignalpegels und völlig unabhängig von dem Lautsprechersignal ist. Nach einmaliger Justierung der Schaltungsanordnung nach Einbau am Einsatzort arbeitet die Schaltungsanordnung über den gesamten Steuer- oder Regelbereich der Lautstärke des Lautsprechers stabil. Ein Aufschaukeln der Schaltungsanordnung mit selbsttätig zunehmender oder absinkender Lautstärke des Lautsprechers ist
nicht möglich, da die Stellgröße für den Lautstärkeregler
über den gesamten Stell- oder Regelbereich unabhängig von
dem Ausgangssignal des Lautstärkereglers bzw. dem Nutzsignal des Lautsprechers ist.

Die Quadrierung der Ausgangsspannungen von Lautstärkeregler und Mikrofon kann sowohl vor der Gleichrichtung
als auch nach der Gleichrichtung sowie gleichzeitig zusammen mit der Gleichrichtung der Ausgangsspannungen erfolgen. Bevorzugt wird gemäß einer vorteilhaften Ausführungsform der Erfindung die Quadrierung der Ausgangsspannungen vor der Gleichrichtung und damit die Anordnung der Quadriernetzwerke vor den Gleichrichtstufen, gegebenenfalls auch die gleichzeitige Quadrierung und Gleichrichtung.

Gemäß einer bevorzugten Ausführungsform der Erfindung ist
zur Grundjustierung und Abstimmung der Schaltungsanordnung
im Leitungszweig zwischen dem Ausgang des Lautstärkereglers und dem Eingang der Summierschaltung mindestens ein
justierbares Abstimmglied vorgesehen. Mit diesem Abstimmglied wird die Schaltungsanordnung in den Schaltungskonstanten der einzelnen Bausteine so lange abgestimmt,
bis ein Einfluß des Lautsprechersignals bei der Lautstärkenveränderung des Lautsprechers, sei es durch Änderung
des Störgeräuschpegels oder durch Änderung der Grundeinstellung des Lautstärkereglers, nicht mehr wahrgenommen
werden kann. Diese Abstimmung der Schaltungsanordnung muß
selbstverständlich an ihrem Einsatzort vorgenommen werden,
da die Abstimmung u.a. auch abhängig ist von der Anordnung
von Lautsprecher und Mikrofon und von der Ausgestaltung
des Hörraumes, in welchem Lautsprecher und Mikrofon angeordnet sind.

Die Erfindung ist anhand eines in der Zeichnung dargestellten Ausführungsbeispieles dargestellt. Dabei zeigt
die Zeichnung ein Blockschaltbild einer Schaltungsanordnung zum selbsttätigen Einstellen der Lautstärke eines
Lautsprechers für ein Autoradio.

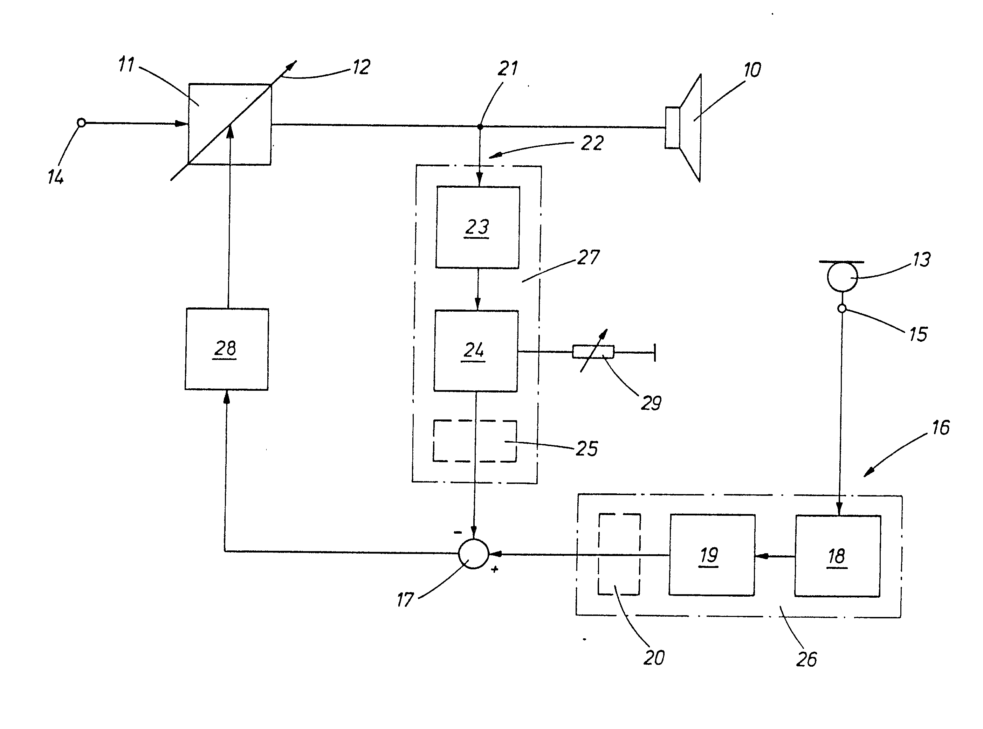

In der dargestellten Schaltungsanordnung ist mit 10 ein
Lautsprecher, mit 11 ein Lautstärkeregler und mit 12 ein
durch ein Pfeilsymbol angedeutetes Stellglied bezeichnet,
das dem Lautstärkeregler 11 zugeordnet ist. In bekannter
Weise können dabei der Lautstärkeregler 11 und das Stellglied 12 von einem integrierten Verstärker gebildet sein.
Ein solcher Verstärker ist üblicherweise als Niederfrequenz-Verstärker in Autoradios bereits enthalten, wobei
an seinem Eingang 14 ein manuell bedienbarer Lautstärkeeinsteller angeschlossen ist, mit welchem eine Grundeinstellung des Lautstärkereglers vorgewählt werden kann.
Ein solcher integrierter Verstärker ist auch in der Patentanmeldung P 29 04 920.5 (Fig. 2) beschrieben.

Die Schaltungsanordnung weist weiterhin ein Mikrofon 13
auf, das sowohl das Lautsprechersignal als auch das Störgeräuschsignal im Fahrgastraum des Autos erfaßt. Das
Mikrofon 13 ist entweder ebenso wie die Schaltungsanordnung
im Radiogehäuse oder in dessen Nähe angeordnet. Das Mikrofon 13 erzeugt entsprechend dem aufgenommenen Störgeräusch-
und Lautsprechersignal eine entsprechende Ausgangsspannung,
die sich naturgemäß aus einer Spannungskomponente, die
von dem Störgeräuschsignal herrührt, und aus einer
Spannungskomponente, die von dem Lautsprechersignal herrührt, zusammensetzt. Der Ausgang 15 des Mikrofons 13 ist
über einen Leitungszweig 16 mit dem Eingang einer Summierschaltung 17 verbunden. In dem Leitungszweig 16 ist ein
Quadriernetzwerk 18, eine Gleichrichtstufe 19 und vorzugsweise ein der Gleichrichtstufe 19 nachgeschaltetes Siebglied 20 angeordnet. Vorzugsweise ist dabei das Quadriernetzwerk 18 unmittelbar an dem Ausgang 15 des Mikrofons 13 angeschlossen, während die Gleichrichtstufe 19
mit Siebglied 20 zwischen dem Quadriernetzwerk 18 und der
Summierschaltung 17 angeschlossen ist.

Der Ausgang 21 des Lautstärkereglers 11 ist einerseits
mit dem Lautsprecher 10 und andererseits über einen Leitungszweig 22 mit der Summierschaltung 17. Ebenso wie
im Leitungszweig 16 zwischen Mikrofon 13 und Summierschaltung 17 ist in dem Leitungszweig 22 ebenfalls ein Quadriernetzwerk 23, eine Gleichrichtstufe 24 und vorzugsweise
ein der Gleichrichtstufe nachgeschaltetes Siebglied 25
angeordnet. Auch hier ist wiederum das Quadriernetzwerk
23 dem Ausgang 21 des Lautstärkereglers 11 unmittelbar
nachgeschaltet, während die Gleichrichtstufe 24 mit Siebglied 25 zwischen Quadriernetzwerk 23 und Eingang der
Summierschaltung 17 angeordnet ist. Die in den Leitungszweigen 16 und 22 angeordneten Baugruppen Quadriernetzwerk 18, 23, Gleichrichtstufe 19, 24 und Siebglied 20, 25
können jeweils zu einer Schaltungseinheit 26 bzw. 27 zusammengefaßt sein.

Dem an dem Leitungszweig 16 angeschlossenen Eingang der
Summierschaltung 17 wird nunmehr der quadratische Wert
der gleichgerichteten Mikrofonausgangsspannung zugeführt,
während an dem zweiten, mit dem Leitungszweig 22 verbundenen Eingang der Summierschaltung 17 der negative quadratische Wert der Ausgangspannung des Lautstärkereglers 11
ansteht. Die Summierschaltung 17 bildet nunmehr die
Differenz zwischen den Quadraten der gleichgerichteten
Ausgangsspannungen von Mikrofon 13 und Lautstärkeregler 11.
Diese Differenz steht als Ausgangsspannung an dem Ausgang
der Summierschaltung 17 an, die über eine Anpassungsstufe
28 dem Eingang des Stellgliedes 12 zugeführt wird. Die Anpassungsstufe 28 wandelt die Ausgangsspannung der Summierschaltung 17 in eine geeignete Stellgröße um.

Aufbau und Wirkungsweise der Summierschaltung 17 ist bekannt, so daß auf eine ausführliche Beschreibung hier verzichtet wird. Das gleiche gilt für die Quadriernetzwerke
18 und 23. Summierschaltungen und Quadriernetzwerke sind
z.B. in der Literaturstelle TIETZE, SCHENK "Halbleiter-
Schaltungstechnik", 3. Auflage,1974, Seite 203 ff.
und Seite 271 ff. beschrieben.

In dem Leitungszweig 22 zwischen Lautstärkereglerausgang
21 und Summierschaltung 17 ist mindestens ein justierbares
Abstimmglied 29 angeordnet, das in der Zeichnung durch ein
Potentiometersymbol schematisch dargestellt ist. Mit diesem Abstimmglied 29 läßt sich nunmehr die Schaltungsanordnung derart abstimmen, daß sich in der Summierschaltung
die quadratischen Werte einerseits der gleichgerichteten
Ausgangsspannung des Lautstärkereglers 11 und andererseits
der gleichgerichteten Spannungskomponente der Mikrofonausgangsspannung, die von dem Lautsprechersignal herrührt,
gegenseitig völlig aufheben. Eine solche Abstimmung der
Schaltungsanordnung muß nach Einbau der Schaltungsanordnung
in das entsprechende Kraftfahrzeug vorgenommen werden, da
die Schaltungskonstanten der Schaltungsanordnung auch von
der Anordnung von Mikrofon 13 und Lautsprecher 10 und von
der Art des Kraftfahrzeuginnenraums abhängig ist. Die
richtige Abstimmung der Schaltungsanordnung läßt sich
daran erkennen, daß ein Einfluß des Lautsprechersignals
auf die Lautstärkeneinstellung nicht mehr wahrgenommen
werden kann, wenn der Störgeräuschpegel z.B. stark angehoben wird. Hier stellt sich die Lautstärke des Lautsprechers auf einen neuen Pegel ein und bleibt konstant. Das
gleiche läßt sich auch nachweisen, wenn die Grundeinstellung des Lautstärkereglers 11 von Hand extrem geändert

- 8 -   Blaupunkt-Werke GmbH
         R.Nr. 1643

wird. Auch hier bleibt die Lautstärke des Lautsprechers
10 auf dem neu eingestellten Pegel konstant.

-.-.-.-.-.-.-

Blaupunkt-Werke GmbH                    9. Oktober 1979
3200 Hildesheim                         R.Nr. 1643

Patentansprüche

1. Schaltungsanordnung zum selbsttätigen Einstellen der
   Lautstärke eines Lautsprechers in Abhängigkeit von
   einem am Lautsprecherort herrschenden Störgeräuschpegel,
   insbesondere für mobile Rundfunkempfänger, wie Autoradios od. dgl., mit einem dem Lautsprecher vorgeordneten Lautstärkeregler mit zugeordnetem Stellglied,
   mit einem Lautsprecher- und Störgeräuschsignal erfassenden und eine entsprechende Ausgangsspannung erzeugenden Mikrofon, mit jeweils die Ausgangsspannungen
   von Lautstärkeregler und Mikrofon gleichrichtenden
   Gleichrichtstufen und mit einer die gleichgerichteten
   Ausgangsspannungen mit entgegengesetzter Polarität
   verknüpfenden Summierschaltung, deren Ausgangsspannung
   als Stellgröße dem Stellglied des Lautstärkereglers
   zugeführt ist, d a d u r c h  g e k e n n z e i c h -
   n e t , daß in den Leitungszweigen (16, 22) zwischen
   den Ausgängen (15, 21) von Mikrofon (13) und Lautstärkeregler (11) einerseits und der Summierschaltung (17)
   andererseits je ein Quadriernetzwerk (18, 23) angeordnet ist, so daß in der Summierschaltung (17) die
   Quadrate der gleichgerichteten Ausgangsspannungen von
   Mikrofon (13) und Lautstärkeregler (11) voneinander
   substrahiert werden.

2. Schaltungsanordnung nach Anspruch 1, d a d u r c h
g e k e n n z e i c h n e t , daß die Quadriernetzwerke (18, 23) jeweils zwischen den Ausgängen (15, 21)
von Mikrofon (13) bzw. Lautstärkeregler (11) und den
Gleichrichtstufen (19, 24) angeordnet sind.

3. Schaltungsanordnung nach Anspruch 1 oder 2, d a -
d u r c h   g e k e n n z e i c h n e t , daß den
Gleichrichtstufen (19, 24) Siebglieder (20, 25) nachgeschaltet sind.

4. Schaltungsanordnung nach einem der Ansprüche 1 - 3,
d a d u r c h   g e k e n n z e i c h n e t , daß im
Leitungszweig (22) zwischen Lautstärkereglerausgang
(21) und Summierschaltung (17) mindestens ein justierbares Abstimmglied (29) vorgesehen ist, mittels welchem
die Schaltungsanordnung derart abstimmbar ist, daß ein
Einfluß des Lautsprechersignals nicht mehr wahrgenommen
werden kann.

5. Schaltungsanordnung nach einem der Ansprüche 1 - 4,
d a d u r c h   g e k e n n z e i c h n e t , daß
zwischen Summierschaltung (17) und Stellglied (12)
eine Anpassungsstufe (28) eingeschaltet ist, welche
den am Ausgang der Summierschaltung (17) anstehenden
quadratischen Wert der von dem Störgeräuschsignal herrührenden Spannungskomponente der Mikrofonausgangsspannung in eine geeignete Stellgröße umwandelt.

- . - . - . - . - . - . - . -

Europäisches Patentamt

Nummer der Anmeldung

EP 80 10 4994

**EUROPÄISCHER RECHERCHENBERICHT**

| EINSCHLÄGIGE DOKUMENTE | | | KLASSIFIKATION DER ANMELDUNG (Int CI ⁴) |
|---|---|---|---|
| Kategorie | Kennzeichnung des Dokuments mit Angabe, soweit erforderlich, der maßgeblichen Teile | betrifft Anspruch | H 03 G 3/32 |
| | DE - A - 2 717 069 (OSTERTAG)<br><br> * Figur 2; Seite 8, Zeile 25 bis Seite 11, Zeile 8; Seite 13, Zeilen 10-14 *<br><br>-- | 1,2,4,5 | |
| | GB - A - 485 005 (H. BOUCKE)<br><br> * Figuren; Seite 1, Zeile 106 bis Seite 2, Zeile 63; Seite 2 Zeilen 100-117 *<br><br>-- | 1,3 | |
| | DE - A - 2 435 956 (H. NIPPOLD)<br><br> * Figuren; Seite 4, Absatz 3 bis Seite 5, vollständig *<br><br>-- | 1,5 | RECHERCHIERTE SACHGEBIETE (Int CI.³)<br><br>H 03 G |
| | DE - A - 1 762 823 (W. RUPPELT)<br><br> * Figur 2; Seite 5, Zeile 11 bis Seite 8, vollständig *<br><br>---- | 1,4 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 26-01-1981 | GYSEN |

EPA form 1503.1 06.78